# EUROPEAN PATENT APPLICATION

(11) **EP 4 723 393 A1**
(43) Date of publication of application: **08.04.2026**
(21) Application number: 24815737.2
(22) Date of filing: 13.05.2024
(51) Int. Cl.: H01R 13/627, H01R 13/639

(54) **SIGNAL TRANSMISSION DEVICE**

(30) Priority: 31.05.2023 KR 20230069808
(71) Applicant: KMW Inc., Hwaseong-si, Gyeonggi-do 18462 (KR)
(72) Inventor: KIM, Duk Yong, Yongin-si Gyeonggi-do 17086 (KR); KIM, Joung-hoe, Hwaseong-si Gyeonggi-do 18462 (KR); RYU, Chi Back, Hwaseong-si Gyeonggi-do 18392 (KR)
(74) Representative: impuls legal PartG mbB
(86) International application number: PCT/KR2024/006456
(87) International publication number: WO 2024/248359

(57) **Abstract**

According to an embodiment of the present disclosure, provided is a signal transmission device comprising: a shielding structure having at least a portion of an upper surface open and including an accommodating space inside thereof; a cover including a first through-hole and coupled to an open portion of the upper surface; a first dielectric member disposed within the accommodating space and having a second through-hole formed in a center; a signal transmission line penetrating an outer portion of the first dielectric member and having a third through-hole formed on one side; a first connector disposed to penetrate the first through-hole and the third through-hole; and a first elastic member disposed between the signal transmission line and the first connector and contacting the signal transmission line and the first connector.

## Description

### [Technical Field]

The present disclosure relates to a signal transmission device.

### [Background Art]

The content described in this section merely provides background information on the present disclosure and does not constitute prior art.

A connector is an electronic component that connects devices. A connector is disposed between devices and transmits signals or delivers received signals. A connector can be connected to a printed circuit board (PCB), an antenna board, a filter, and the like. A connector is typically inserted into terminals of devices to connect the devices.

For connectors to function properly, a certain distance must be maintained between devices. If the distance between devices is not constant, a connector may not make proper contact with the terminals of the devices. Failure to properly connect a connector can lead to various problems. Specifically, electrical signals may not be transmitted smoothly, resulting in noise, which can degrade communication quality or speed.

Devices are not always used in a fixed state. If the distance between devices changes, contact between the devices and the connector may be reduced, which can cause problems with electrical signal transmission. That is, since the distance between devices cannot always be maintained constant, a connector or connector connection structure that does not deteriorate in performance even when the distance between devices changes is required.

### [Disclosure]

### [Technical Problem]

Accordingly, the present disclosure is intended to solve such problems, and a main object thereof is to provide a connection structure that includes an elastic member connecting a connector and a signal transmission line, enabling signal transmission even when the position of the connector changes.

Furthermore, a main object of the present disclosure is to reduce costs by providing a compact signal transmission device having a simple structure.

### [Technical Solution]

In order to achieve the above purpose, in accordance with one embodiment of the present disclosure, there is provided a signal transmission device comprising: a shielding structure having at least a portion of an upper surface open and including an accommodating space inside thereof; a cover including a first through-hole and coupled to an open portion of the upper surface; a first dielectric member disposed within the accommodating space and having a second through-hole formed in a center; a signal transmission line penetrating an outer portion of the first dielectric member and having a third through-hole formed on one side; a first connector disposed to penetrate the first through-hole and the third through-hole; and a first elastic member disposed between the signal transmission line and the first connector and contacting the signal transmission line and the first connector.

### [Advantageous Effects]

According to the present embodiment as described above, the signal transmission device can transmit signals even when the position of the connector changes by including an elastic member.

Furthermore, it is possible to provide a compact signal transmission device having a simple structure to reduce costs.

### [Description of Drawings]

FIG. 1 is a perspective view of a signal transmission line, a first connector, and a first elastic member according to an embodiment of the present disclosure.
FIG. 2 is a cross-sectional view of a signal transmission device according to an embodiment of the present disclosure.
FIG. 3 is an exploded perspective view of the signal transmission line, the first connector, and the first elastic member according to an embodiment of the present disclosure.
FIG. 4 is a cross-sectional view illustrating a portion of the signal transmission device according to an embodiment of the present disclosure.

### [Mode for Invention]

Hereinafter, some embodiments of the present disclosure will be described in detail with reference to the accompanying drawings. It is to be noted that in giving reference numerals to components of each of the accompanying drawings, the same components will be denoted by the same reference numerals even though they are illustrated in different drawings. Further, in describing exemplary embodiments of the present invention, well-known functions or constructions will not be described in detail since they may unnecessarily obscure the understanding of the present invention.

Terms 'first', 'second', i), ii), a), b), and the like, will be used in describing components according to embodiments of the present disclosure. These terms are only for distinguishing the components from other components, and the nature, sequence, order, or the like of the components are not limited by the terms. Throughout the present specification, unless explicitly described to the contrary, "including" or "comprising" any components will be understood to imply the inclusion of other elements rather than the exclusion of any other elements.

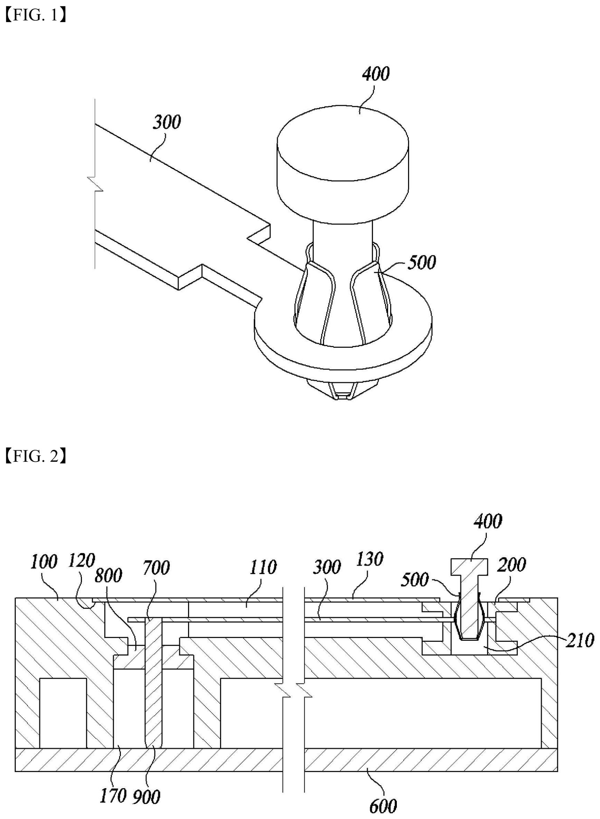

FIG. 1 is a perspective view of a signal transmission line, a first connector, and a first elastic member according to an embodiment of the present disclosure.

FIG. 2 is a cross-sectional view of a signal transmission device according to an embodiment of the present disclosure.

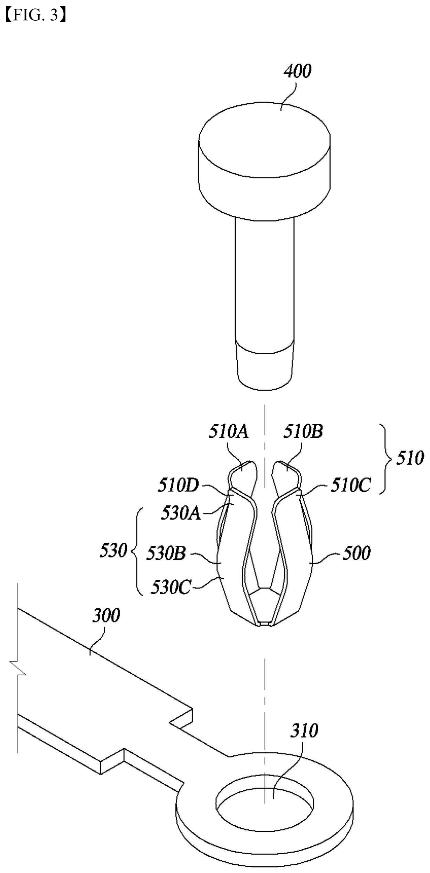

FIG. 3 is an exploded perspective view of the signal transmission line, the first connector, and the first elastic member according to an embodiment of the present disclosure.

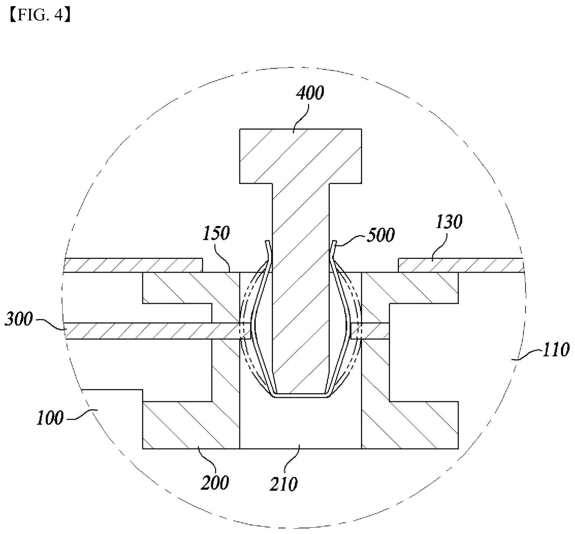

FIG. 4 is a cross-sectional view illustrating a portion of the signal transmission device according to an embodiment of the present disclosure.

Referring to FIG. 1 to FIG. 4, a signal transmission device apparatus 1 includes all or some of a shielding structure 100, a cover 130, a first dielectric member 200, a signal transmission line 300, a first connector 400, a first elastic member 500, a substrate 600, a second connector 700, a second dielectric member 800, and a second elastic member 900.

The shielding structure 100 blocks electromagnetic waves or prevents signal interference. According to an embodiment, the shielding structure 100 may be manufactured using aluminum or magnesium. The shielding structure 100 forms a closed structure together with the cover 130, thereby protecting components placed inside from external interference. The shape of the shielding structure 100 is not limited to the shape illustrated in FIG. 2.

At least a portion of the upper surface of the shielding structure 100 may be open. The cover 130 is coupled to the open portion of the upper surface of the shielding structure 100. The cover 130 includes a first through-hole 150. According to an embodiment, the cover 130 may be mounted in a receiving groove 120 of the shielding structure 100. Referring to FIG. 2, the receiving groove 120 may be formed on the upper surface of the shielding structure 100.

According to an embodiment, the shielding structure 100 may be a shield can. Shield cans are used in communication equipment, computers, electronic devices, etc. Shield cans can protect electronic components placed thereinside from external electromagnetic waves.

The shielding structure 100 includes an accommodating space 110 and a fourth through-hole 170.

The accommodating space 110 is a space formed within the shielding structure 100. The first dielectric member 200, the second dielectric member 800, and the signal transmission line 300 may be accommodated within the accommodating space 110. The shape of the accommodating space 110 is not limited to the shape illustrated in FIG. 2 and FIG. 4.

The first through-hole 150 is formed in the cover 130. The first connector 400 is inserted into the first through-hole 150. According to an embodiment, the diameter of the first through-hole 150 may be greater than the diameter of a second through-hole 210.

The fourth through-hole 170 is formed in a lower surface of the shielding structure 100. The second connector 700 may be disposed inside the fourth through-hole 170.

The first dielectric member 200 is disposed in the accommodating space 110 of the shielding structure 100. According to an embodiment, the upper surface of the first dielectric member 200 may be disposed to contact the lower surface of the cover 130.

The first dielectric member 200 enhances electrical stability, thereby assisting in the stable operation of the signal transmission device 1. According to an embodiment, the first dielectric member 200 may be formed using Teflon.

The first dielectric member 200 may have the second through-hole 210 formed in the center. A portion of the signal transmission line 300 may be inserted into the inner side of the second through-hole 210. In this case, the portion of the signal transmission line 300 may be disposed to penetrate the outer side of the first dielectric member 200.

The signal transmission line 300 may be disposed between the first connector 400 and the second connector 700. In this case, the second connector 700 may transmit a signal to the signal transmission line 300, and the signal transmission line 300 may transmit a signal to the first connector 400 or the first elastic member 500.

According to an embodiment, the signal transmission line 300 may penetrate the outer side of the first dielectric member 200. One side of the signal transmission line 300 is in contact with the first elastic member 500.

A third through-hole 310 may be formed on one side of the signal transmission line 300. The third through-hole 310 may be located inside the second through-hole 210.

The other side of the signal transmission line 300 may be located inside the fourth through-hole 170. The other side of the signal transmission line 300 may be connected to the second connector 700.

The diameter of the third through-hole 310 may be smaller than the diameter of the second through-hole 210. In this case, the first elastic member 500 may be disposed to contact the third through-hole 310.

The first connector 400 may be disposed to penetrate the first through-hole 150 and the third through-hole 310. A portion of the first connector 400 may be positioned inside the second through-hole 210.

The signal transmission device 1 according to the present disclosure may be coupled with a device (not shown) other than the signal transmission device 1. In this case, the first connector 400 connects the signal transmission device 1 to the other device. For example, the other device may be a filter (not shown). In this case, the signal transmission device 1 may be connected to the filter. In this case, the first connector 400 is connected to the filter. The first connector 400 may be unified with the filter.

The shape of the first connector 400 is not limited to the shape illustrated in FIG. 1 to FIG. 4. The first connector 400 may have any shape that allows simultaneous connection of the signal transmission device 1 with another device.

According to an embodiment, the position of the first connector 400 may vary. Specifically, the first connector 400 is positioned inside the second through-hole 210 and can move up, down, left, and right. That is, the position of the first connector 400 inside the second through-hole 210 can change. Even when the position of the first connector 400 changes in this way, the contact between the third through-hole 310, the first elastic member 500, and the first connector 400 is maintained. This is because the first elastic member 500 elastically deforms and comes into contact with the third through-hole 310 and the first connector 400. Even when the position of the first connector 400 changes, the third through-hole 310, the first elastic member 500, and the first connector 400 are in contact, and therefore, the signal transmission device 1 can transmit a signal.

When the signal transmission device 1 according to the present disclosure is coupled to another device (not shown), the distance between the signal transmission device 1 and the other device may vary. As described above, the position of the first connector 400 can vary. Even when the distance between the signal transmission device 1 and the other device varies, the first connector 400 can maintain contact with the signal transmission device 1 and the other device. That is, even when the distance between the signal transmission device 1 and the other device varies, the signal transmission device 1 can transmit a signal to the other device.

The central axes of the first through-hole 150 to the third through-hole 310 may coincide with each other. If the central axes of the first through-hole 150 to the third through-hole 310 do not coincide with each other, the first connector 400 and the first elastic member 500 are difficult to place inside the first through-hole 150 to the third through-hole 310. When the central axes of the first through-hole 150 to the third through-hole 310 coincide with each other, the first connector 400 and the first elastic member 500 can be disposed inside the first through-hole 150 to the third through-hole 310 and can move up, down, left, and right.

The first elastic member 500 is disposed between the signal transmission line 300 and the first connector 400. The first elastic member 500 contacts the signal transmission line 300 and the first connector 400. The signal transmission line 300 transmits a signal to the first elastic member 500, and the first elastic member 500 transmits a signal to the first connector 400.

According to an embodiment, the first elastic member 500 is disposed to penetrate the first through-hole 150 and the third through-hole 310. In an embodiment, the first elastic member 500 is disposed within the second through-hole 210. In this case, at least a portion of the first elastic member 500 may protrude outside the second through-hole 210. In an embodiment, one surface of the first elastic member 500 may contact the lower surface of the first connector 400.

The first elastic member 500 may include a plurality of support bodies 510 extending from the one surface thereof. Referring to FIG. 1 to FIG. 4, the plurality of support bodies 510 includes a first support body 510A to a fourth support body 510D, but the number and shape of the plurality of support bodies 510 are not limited to those disclosed in FIG. 1 to FIG. 4.

The plurality of support bodies 510 may include at least one bending portion 530. Depending on the number and bending angle of the bending portions, the degree to which the plurality of support bodies 510 are deformed, the elasticity of the plurality of support bodies 510, the contact area, etc., vary. Here, the contact area refers to the contact area between the first elastic member 500 and the first connector 400 or the contact area between the first elastic member 500 and the third through-hole 310.

Referring to FIG. 1 to FIG. 4, the at least one bending portion 530 includes a first bending portion 530A to a third bending portion 530C, but the at least one bending portion 530 is not limited to the number and shape illustrated in FIG. 1 to FIG. 4.

Each inner side of the plurality of support bodies 510 contacts the outer surface of the first connector. Each outer side of the plurality of support bodies 510 contacts the inner surface of the third through-hole 310.

The plurality of support bodies 510 may be elastically deformed by the third through-hole 310. Referring to FIG. 4, the plurality of support bodies 510 is compressed by the third through-hole 310. That is, the plurality of support bodies 510 contact the third through-hole 310 and the first connector 400 while being elastically deformed.

The first connector 400 and the first elastic member 500 can be joined to each other. In an embodiment, the first connector 400 and the first elastic member 500 can be joined to each other using welding or soldering. In this case, when the first connector 400 moves, the first elastic member 500 also moves. The degree of elastic deformation and shape of the first elastic member 500 differ depending on the position where the first elastic member 500 is positioned. Even when the position of the first elastic member 500 changes, the first elastic member 500 maintains contact with the third through-hole 310 and the first connector 400. Since the contact is maintained, the first connector 400 can receive a signal from the signal transmission line 300 regardless of the position.

The substrate 600 may be disposed at the bottom of the shielding structure 100. The substrate 600 is connected to the second connector 700. The substrate 600 transmits a signal to the second connector 700. According to an embodiment, the substrate 600 may be a printed circuit board (PCB).

The second connector 700 may be connected to the substrate 600. The second connector 700 may be disposed inside the fourth through-hole 170 formed in the lower surface of the shielding structure 100. The second connector 700 may be connected to the other side of the signal transmission line 300. The shape of the second connector 700 is not limited to the shape illustrated in FIG. 2. The second connector 700 may have any shape that allows the signal transmission line 300 and the substrate 600 to be simultaneously connected to the second connector 700.

The second dielectric member 800 may be disposed to surround the second connector 700. In this case, the second connector 700 may penetrate the center of the second dielectric member 800. The second dielectric member 800 improves electrical stability, thereby assisting in the stable operation of the signal transmission device 1. According to an embodiment, the second dielectric member 800 may be formed using Teflon.

The spirit of the present embodiment is illustratively described hereinabove. It will be appreciated by those skilled in the art to which the present embodiment pertains that various modifications and alterations may be made without departing from the essential characteristics of the present embodiment. Accordingly, the present embodiments are not to limit the spirit of the present embodiment, but are to describe the spirit of the present embodiment. The technical idea of the present embodiment is not limited to these embodiments. The scope of the present embodiment should be interpreted by the following claims, and it should be interpreted that all the spirits equivalent to the following claims fall within the scope of the present embodiment.

### [DESCRIPTION OF REFERENCE NUMERALS]

1: signal transmission device 100: shielding structure
110: accommodating space 130: cover
150: first through-hole 170: fourth through-hole
200: first dielectric member 210: second through-hole
300: signal transmission line 310: third through-hole
400: first connector 500: first elastic member
510: first support body 530: at least one bending portion
600: substrate 700: second connector
800: second dielectric member 900: second elastic member

### [CROSS-REFERENCE TO RELATED APPLICATION]

This application claims the benefit of and priority to Korea Patent Application No. 1 0-2023-0069808, filed on May 31, 2023, the entire disclosures of which are hereby incorporated herein by reference in its entirety.

## Claims

1. A signal transmission device comprising:
a shielding structure having at least a portion of an upper surface open and including an accommodating space inside thereof;
a cover including a first through-hole and coupled to an open portion of the upper surface;
a first dielectric member disposed within the accommodating space and having a second through-hole formed in a center;
a signal transmission line penetrating an outer portion of the first dielectric member and having a third through-hole formed on one side;
a first connector disposed to penetrate the first through-hole and the third through-hole; and
a first elastic member disposed between the signal transmission line and the first connector and contacting the signal transmission line and the first connector.

2. The signal transmission device of claim 1, wherein the cover is mounted in a receiving groove formed on the upper surface of the shielding structure.

3. The signal transmission device of claim 1, wherein an upper surface of the first dielectric member is disposed to contact a lower surface of the cover.

4. The signal transmission device of claim 1, wherein the third through-hole is located inside the second through-hole.

5. The signal transmission device of claim 1, wherein a portion of the first connector is located inside the second through-hole.

6. The signal transmission device of claim 1, wherein central axes of the first through-hole to the third through-hole coincide with each other.

7. The signal transmission device of claim 1, wherein a diameter of the first through-hole is greater than a diameter of the second through-hole.

8. The signal transmission device of claim 1, wherein a diameter of the third through-hole is smaller than a diameter of the second through-hole.

9. The signal transmission device of claim 1, wherein one surface of the first elastic member contacts a lower surface of the first connector.

10. The signal transmission device of claim 1, wherein the first elastic member includes a plurality of support bodies extending from one surface thereof.

11. The signal transmission device of claim 10, wherein the plurality of support bodies includes at least one bending portion.

12. The signal transmission device of claim 10, wherein each inner side of the plurality of support bodies contacts an outer surface of the first connector.

13. The signal transmission device of claim 10, wherein each outer side of the plurality of support bodies contacts an inner surface of the third through-hole.

14. The signal transmission device of claim 10, wherein the plurality of support bodies are elastically deformed by the third through-hole.

15. The signal transmission device of claim 1, wherein the first connector and the first elastic member are joined to each other by welding or soldering.

16. The signal transmission device of claim 1, further comprising:
a substrate disposed below the shielding structure; and
a second connector connected to the substrate,
wherein the second connector is disposed inside a fourth through-hole formed in a lower surface of the shielding structure and is connected to the other side of the signal transmission line.

17. The signal transmission device of claim 16, further comprising a second dielectric member disposed to surround the second connector.
